Europäisches Patentamt

European Patent Office

Office européen des brevets

(11) Veröffentlichungsnummer: **0 477 866 A2**

## (12) EUROPÄISCHE PATENTANMELDUNG

(21) Anmeldenummer: **91116246.9**

(22) Anmeldetag: **24.09.91**

(51) Int. Cl.⁵: **H03K 19/173**

(30) Priorität: **27.09.90 DE 4030605**

(43) Veröffentlichungstag der Anmeldung:
**01.04.92 Patentblatt 92/14**

(84) Benannte Vertragsstaaten:
**DE FR GB IT NL**

(71) Anmelder: **SIEMENS AKTIENGESELLSCHAFT**
**Wittelsbacherplatz 2**
**W-8000 München 2(DE)**

(72) Erfinder: **Schlachter, Hans-Heiner, Dipl.-Ing.**
**Johans-Langmantel-Strasse 40**
**W-8027 Neuried(DE)**

(54) **Gate Array Komponentenanordnung.**

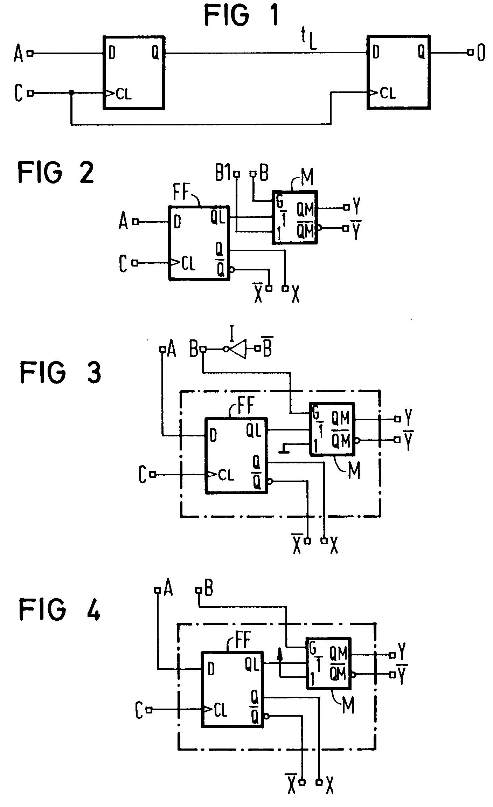

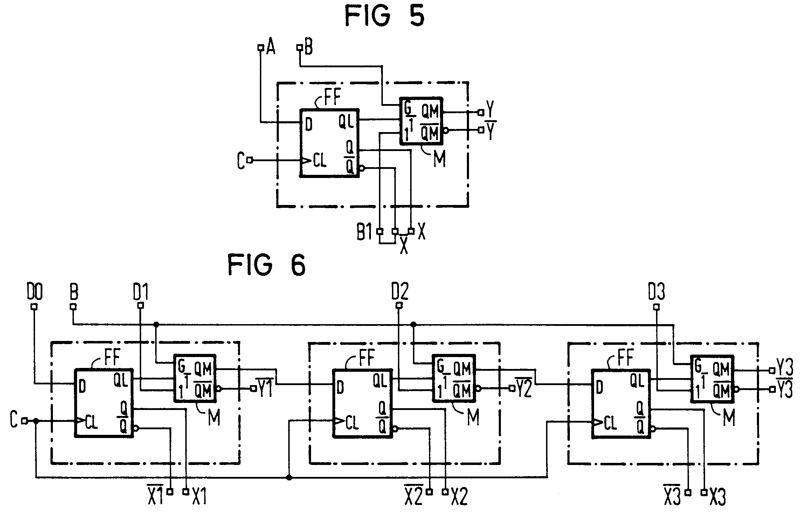

(57) Zur Optimierung des Laufzeitverhaltens einer Gate Array Komponentenanordnung mit einem Speicherelement (FF), das insbesondere zum Aufbau von Schieberegistern (Figur 6) Verwendung findet, ist vorgesehen, dem Speicherelement (FF) ausgangsseitig einen Multiplexer (M) nachzuschalten. Damit lassen sich eine definierte Zusatzlaufzeit zur Laufzeit des Speicherelements (FF), eine zusätzliche Logikfunktion am Ausgang (QL) des Speicherelements sowie Ausgänge der Komponenten (Figur 2) mit unterschiedlicher Schaltgeschwindigkeit $(X, \overline{X}; Y, \overline{Y})$ erreichen.

FIG 2

EP 0 477 866 A2

Die Erfindung betrifft eine Gate Array Komponentenanordnung mit einem taktgesteuerten Flip-Flop sowie eine Verwendung dieser Anordnung.

Gate Array Anordnungen sind bekannt (z.B. Hitachi Review Vol. 33 (1984) Nr. 5, S. 261 - 266). Bei solchen Gate Array Anordnungen werden auf einem Chip Bereiche vorgesehen, auf denen Grundzellen realisiert sind. Die Grundzellen bestehen aus bipolaren oder MOS-Transistoren, die in bestimmter Weise in den Bereichen angeordnet sind. Durch Verbindung der Transistoren pro Grundzelle kann die Grundzelle zur Realisierung einer Grundfunktion spezifiziert werden und ihr z.B. eine logische Funktion oder eine Speicherfunktion gegeben werden.

Bei der Realisierung schieberegisterähnlicher Strukturen in Gate Arrays mit extrem kurzen Schaltzeiten treten Haltezeitverletzungen auf. Schieberegister bestehen üblicherweise aus Ketten von Flip-Flops, die es ermöglichen, eine am Eingang angelegte Information mit jedem Takt um ein Flip-Flop weiterzuschieben. Nach dem Durchlaufen der gesamten Kette steht die Information am Ausgang verzögert, aber sonst unverändert zur Verfügung. Am Beispiel der Figur 1 wird eine Haltezeitverletzung erläutert. Figur 1 zeigt zwei hintereinandergeschaltete Flip-Flops. Vorgesehen sind Master-Slave-Flip-Flops mit einem Dateneingang D und einem Datenausgang Q. Bei diesen flankengetriggerten Flip-Flops wird die Zeitspanne zwischen der wirksamen Flanke des Takts und dem Erscheinen der übernommenen Daten am Ausgang Q als Laufzeit des Flip-Flops bezeichnet. Der Dateneingang D des ersten Flip-Flops liegt an der Eingangsklemme A, während sein Datenausgang Q über die Leitung mit der Laufzeit $t_L$ mit dem Dateneingang D des zweiten Flip-Flops verbunden ist, dessen Ausgang Q an der Ausgangsklemme O angeschlossen ist. Die Takteingänge CL beider Flip-Flops werden gemeinsam von einer Takteingangsklemme C gesteuert.

Bei einem Master-Slave-Flip-Flop wird die Information am Dateneingang D in den Master eingelesen, wenn der Takteingang CL gleich 1 ist. Der Ausgangszustand bleibt in dieser Phase unverändert, da der Slave blockiert ist.

Wenn der Takteingang CL gleich O wird, blokkiert der Master und speichert die zuvor anliegende Information. Gleichzeitig wird der Slave freigegeben und damit die logische Information des Masters an den Ausgang übertragen. Die Datenübertragung erfolgt also bei der negativen Taktflanke. Bei einem extrem schnellschaltenden Flip-Flop und entsprechend kurzer Laufzeit zwischen den beiden Flip-Flops kann es passieren, daß das Durchschalten eines Flip-Flops plus die Übertragung auf der Leitung zwischen den beiden Flip-Flops schneller erfolgt als es die Haltezeit des zweiten Flip-Flops zuläßt.

In diesem Fall würde das zweite Flip-Flop des Schieberegisters zunächst im Master die Dateninformation des vorausgehenden Takts halten, die aber beim Eintreffen der Schaltflanke, d.h. bei der Übernahme vom Master zum Slave kippen kann. Beim Datenübergang Master nach Slave wird dann eine falsche Information erzeugt und gespeichert. Die Schalt- und Laufzeit der Dateninformation des vorausgehenden Flip-Flops muß deshalb länger sein als die Halte- bzw. Bewertungszeit.

Selbst wenn Haltezeitverletzungen bei völlig identischen Flip-Flops und günstiger Plazierung tolerierbar sind, ergeben sich in der Praxis jedoch Schwierigkeiten. Einerseits lassen sich völlig identische Flip-Flops aufgrund üblicher Prozeß- bzw. Herstellungsschwankungen nicht realisieren, andererseits bereitet eine günstige Plazierung Schwierigkeiten, sofern sie rechnergestützt durchgeführt wird. Bei der Simulation eines Gate Array Schieberegisters, z.B. an einer Workstation, führt eine Haltezeitverletzung üblicherweise zum Überlaufen von Fehlerprotokollen, so daß es schwierig ist, tolerierbare von nicht tolerierbaren Haltezeitverletzungen zu finden.

Das Problem der Haltezeitverletzungen wird üblicherweise durch Einfügen zusätzlicher Verzögerungselemente, z.B. zusätzlicher Logik, in den Datenpfad zwischen beiden Flip-Flops gelöst. Dies bedeutet jedoch einen erheblichen Mehraufwand an Verdrahtung und Zellen.

Der Erfindung liegt die Aufgabe zugrunde, eine Komponentenanordnung der eingangs genannten Art zu schaffen, die die Möglichkeit einer verdrahtungsunabhängigen Zusatzlaufzeit am Flip-Flop-Ausgang erlaubt. Weiterhin besteht die Aufgabe, eine Möglichkeit zur Realisierung eines Schieberegisters mit Gate Arrays anzugeben, bei denen Haltezeitverletzungen mit einfachen Mitteln ausgeschlossen werden können.

Diese Aufgabe wird bei einer Anordnung der genannten Art durch die kennzeichnenden Merkmale des Patentanspruchs 1 gelöst. Die Aufgabe wird weiterhin durch die Verwendung einer Anordnung gemäß Patentanspruch 1 als Schieberegisterzelle gelöst.

Die Erfindung hat den Vorteil, daß am Ausgang des Flip-Flops eine zusätzliche Logikfunktion realisiert werden kann. Durch die Integration eines Multiplexers in die Gate Array Komponente ergibt sich eine geringere Verlustleistung als ein diskreter Aufbau sowie die Möglichkeit zur verdrahtungsunabhängigen Realisierung einer Zusatzlaufzeit. Darüberhinaus bietet die Komponente den Vorteil, daß Ausgänge unterschiedlicher Geschwindigkeit zur Verfügung stehen. Bei einem Einsatz als Schieberegisterzelle treten keine Haltezeitverletzungen auf.

Ausgestaltungen der Erfindung sind in Unteransprüchen gekennzeichnet.

Die Erfindung wird nachfolgend anhand von in den Figuren der Zeichnung dargestellten Ausführungsbeispielen näher erläutert. Gleiche Elemente sind mit gleichen Bezugszeichen versehen. Es zeigt:

Figur 1 eine bekannte Schieberegisteranordnung zur Erläuterung möglicher Haltezeitverletzungen,

Figur 2 ein Prinzipschaltbild einer erfindungsgemäßen Gate Array Komponentenanordnung,

Figur 3 ein Prinzipschaltbild einer UND-Verknüpfung mit einer erfindungsgemäßen Gate Array Komponentenanordnung,

Figur 4 ein Prinzipschaltbild einer ODER-Verknüpfung einer erfindungsgemäßen Gate Array Komponentenanordnung,

Figur 5 ein Prinzipschaltbild einer EXOR-Verknüpfung mit einer erfindungsgemäßen Gate Array Komponentenanordnung,

Figur 6 ein Prinzipschaltbild eines parallel ladbaren Schieberegisters mit erfindungsgemäßen Gate Array Komponentenanordnungen und

Figur 7 den Stromlaufplan einer erfindungsgemäßen Gate Array Komponentenanordnung gemäß Figur 2.

Gemäß Figur 2 enthält die erfindungsgemäße Gate Array Komponentenanordnung das Flip-Flop FF und den Multiplexer M. Das Flip-Flop FF ist an seinem Dateneingang D mit der Dateneingangsklemme A und an seinem Takteingang CL mit der Takteingangsklemme C verbunden. Ein Datenausgang QL führt auf einen Dateneingang "$\overline{1}$" des Multiplexers M. Ein weiterer Dateneingang "1" des Multiplexers M ist mit einer Dateneingangsklemme B1, ein Steuereingang G mit einer Steuerklemme B verbunden. Der Multiplexer M hat die komplementären Ausgänge QM bzw. $\overline{QM}$, die mit den Ausgangsklemmen Y bzw. $\overline{Y}$ verbunden sind. Das Flip-Flop FF besitzt weitere komplementäre Ausgänge Q und $\overline{Q}$, die mit weiteren Ausgangsklemmen X bzw. $\overline{X}$ verbunden sind. In einer anderen Ausführungsform der Komponenten ist der Dateneingang "1" mit dem Flip-Flop-Ausgang QL und der Dateneingang "$\overline{1}$" mit der Klemme B1 verbunden.

Je nach Beschaltung des Multiplexers M über die Steuerklemme B bzw. die zweite Dateneingangsklemme B1 lassen sich zusätzliche Logikfunktionen am Flip-Flop-Ausgang realisieren, die dann an den Ausgängen Y bzw. $\overline{Y}$ der Komponentenanordnung vorliegen. Darüberhinaus ermöglicht der Multiplexer M eine Zusatzlaufzeit, die nicht verdrahtungsabhängig ist und eine geringere Verlustleistung besitzt als ein diskreter Aufbau. Für den Anwendungsfall, daß eine kurze Flip-Flop-Schaltzeit ohne zusätzliche Laufzeiten oder Logikfunktionen gefragt ist, besitzt das Flip-Flop FF zwei komplementäre Ausgänge Q und $\overline{Q}$, die zu weiteren Ausgangsklemmen X bzw. $\overline{X}$ führen. Auf diese Weise bietet die erfindungsgemäße Komponentenanordnung die zusätzliche Möglichkeit, ein schnellschaltendes Flip-Flop sowohl allein als auch in Verbindung mit den Möglichkeiten des Multiplexers M gleichzeitig auszunutzen.

Ein erstes Ausführungsbeispiel einer erfindungsgemäßen Komponentenanordnung ist in Figur 3 dargestellt. Dazu ist der Dateneingang "1" des Multiplexers M auf Bezugspotential bzw. logisch O gelegt. Auf diese Weise läßt sich eine logische UND-Verknüpfung $A \cdot \overline{B}$ zwischen der Dateninformation zum Zeitpunkt der vorausgegangenen Halte- bzw. Bewertungsphase an der Dateneingangsklemme A und der Dateninformation an der Steuerklemme erzielen. Die Steuerklemme B ist dazu über einen Inverter I mit der Klemme $\overline{B}$ verbunden, wie in Figur 3, oder an der Steuerklemme B liegt gleich die invertierte Dateninformation. Liegt der Steuereingang B auf logischem Einspotential, so wird der Dateneingang "1" des Multiplexers zu dessen Ausgang durchgeschaltet. Unabhängig vom Logikzustand an der Dateneingangsklemme A zum vorausgegangenen Bewertungszeitpunkt liegt dann die Datenausgangsklemme Y auf logischem Nullpotential. Wird an die Steuerklemme B logisches Nullpotential, d.h. eine logische Eins für $\overline{B}$, gelegt, dann wird der Dateneingang "$\overline{1}$" des Multiplexers zum Ausgang durchgeschaltet. In diesem Fall hängt der Logikpegel an der Ausgangsklemme Y vom Logikzustand des Datenausgangs QL des Flip-Flops ab. Nur für den Fall, daß QL auf logischem Einspotential liegt, befindet sich die Klemme Y ebenfalls auf logischem Einspotential. In allen anderen logischen Kombinationen für die Daten am Ausgang QL bzw. an der Dateneingangsklemme A zum vorausgegangenen Bewertungszeitpunkt und an der Steuerklemme B ist die Datenausgangsklemme Y logisch O. Auf diese Weise erhält man eine logische UND-Verknüpfung zwischen den Daten an der Klemme A zum vorausgegangenen Bewertungszeitpunkt und den gegenüber der Klemme B invertierten Daten $\overline{B}$.

Ein weiteres Ausführungsbeispiel zeigt die Figur 4 mit einer logischen ODER-Verknüpfung. Zu diesem Zweck wird der Dateneingang "1" des Multiplexers M auf Versorgungspotential bzw. logisches Einspotential gelegt. Der Logikzustand an der Ausgangsklemme Y ist nur dann O, wenn mit einem logischen Nullzustand an der Steuerklemme B der Dateneingang "$\overline{1}$" des Multiplexers M durchgeschaltet wird und dieser Dateneingang auf logischem Nullpotential liegt. Das ist nur dann der Fall, wenn die Dateneingangsklemme A zum vorausgegangenen Bewertungszeitpunkt durch den Takt an der Klemme C logisch O war. Bei allen anderen Logikzuständen der Steuerklemme B bzw. am Dateneingang "$\overline{1}$" befindet sich die Datenausgangsklemme Y auf logischem Einspotential. Auf diese Weise werden die Daten an der Klemme A zum vorausgegangenen Bewertungszeitpunkt und an der Klemme B durch ein logisches ODER verknüpft.

Ein drittes Ausführungsbeispiel einer Logikrealisierung mit einer erfindungsgemäßen Gate Array Komponentenanordnung zeigt Figur 5 mit einer logischen EXOR-Verknüpfung. Zu diesem Zweck ist der Dateneingang "1" des Multiplexers bzw. dessen zugeordnete Dateneingangsklemme B1 mit der Datenausgangsklemme $\overline{X}$ bzw. dem Datenausgang $\overline{Q}$ des Flip-Flops verbunden. Bei einem logischen Nullzustand der Steuerklemme B liegt die Datenausgangsklemme Y dann auf logischem Einspotential, wenn der Dateneingang "$\overline{1}$" des Multiplexers M auf logischem Einspotential liegt. Bei einem logischen Einspotential der Steuerklemme B liegt an der Datenausgangsklemme Y dann logisches Einspotential, wenn am Dateneingang "1" des Multiplexers M logisches Einspotential liegt. Das ist dann der Fall, wenn beim Flip-Flop FF der Datenausgang Q auf logischem Nullpotential bzw. der Datenausgang $\overline{Q}$ auf logischem Einspotential liegt. Der Zustand am Ausgang Q entspricht dabei dem Logikzustand an der Dateneingangsklemme A zum vorausgegangenen Bewertungszeitpunkt durch den Takt an der Klemme C. Zwischen A zum vorausgegangenen Bewertungszeitpunkt und B herrscht also eine EXOR-Verknüpfung mit extrem kurzer Schaltzeit bezüglich des Flip-Flop-Ausgangs, da die Verbindung von B1 und $\overline{X}$ quasi eine Intrazellverdrahtung ist.

Figur 6 zeigt als viertes Ausführungsbeispiel für die Verwendung einer erfindungsgemäßen Gate Array Komponentenanordnung ein parallel ladbares Schieberegister. Dazu sind drei erfindungsgemäße Komponenten gemäß Figur 2 hintereinandergeschaltet. Das bedeutet, daß der Ausgang QM eines Multiplexers auf den Dateneingang D der nachfolgenden Komponente geschaltet ist. Der Dateneingang D der ersten Komponente ist mit einer Klemme DO verbunden. Die Dateneingänge "1" der Multiplexer der einzelnen Komponenten sind jeweils mit einer Dateneingangsklemme D1, D2 bzw. D3 verbunden. Die Steuereingänge G der jeweiligen Multiplexer liegen parallel an einer Steuerklemme B und die Takteingänge CL der Flip-Flops der einzelnen Komponenten liegen parallel an der Takteingangsklemme C. Zum Laden des Schieberegisters werden die Daten an die Dateneingangsklemmen D0 bis D3 angelegt und die Steuerklemme B auf logisches Einspotential gesetzt. In diesem Fall steht an den Dateneingängen D der Flip-Flops der einzelnen Komponenten und am Datenausgang Y3 der letzten Komponenten die Logikinformation an den Dateneingangsklemmen D0 bis D3 nach der nächsten aktiven Taktflanke an. Beim Weiterschieben der Dateninformation mit den nachfolgenden Taktsignalen treten keine Haltezeitverletzungen auf, da die Multiplexer M der einzelnen Komponenten auch bei extrem schnellschaltenden Flip-Flops der einzelnen Komponenten eine ausreichend lange Zusatzlaufzeit bringen. Darüberhinaus stehen an den einzelnen Komponenten für weitere Logikverknüpfungen die schnellen Ausgänge Q bzw. $\overline{Q}$ zur Verfügung.

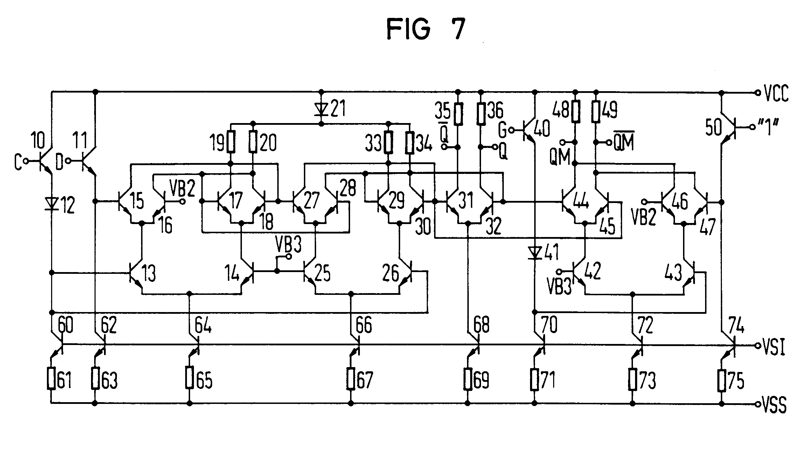

Figur 7 zeigt den Stromlaufplan einer erfindungsgemäßen Komponenten gemäß Figur 2 in der Technik Common Mode Logic (CML). Die Schaltung wird über die Klemmen VCC und VSS mit Spannung versorgt. Die Elemente 10 bis 21 und 25 bis 36 bilden mit ihren Ein- und Ausgängen das Flip-Flop, das aus dem Master mit den Elementen 11 bis 21 und dem Slave mit den Elementen 25 bis 36 sowie 21 besteht. Die Elemente 40 bis 50 bilden mit ihren Ein- und Ausgängen den Multiplexer. Die jeweils aus einem Transistor und einem Widerstand gebildeten paarweisen Elemente 60 bis 75 sind Stromquellen, die die Nutzschaltung versorgen. Die Transistoren 60, 62, 64, 66, 68, 70, 72 und 74 liegen dabei an einem gemeinsamen Anschluß VSI, mit dem die Stromstärke eingestellt werden kann. Die Nutzschaltung aus dem Flip-Flop und dem Multiplexer ist aus Seriesgating-Stufen aufgebaut. Im Ausführungsbeispiel sind zwei Stufen vorgesehen, die an den Refenzpotentialen VB2 und VB3 liegen. Jedes Common Mode Logic (CML)-Gatter besteht im wesentlichen aus einem Differenzverstärker, dessen einer Eingang auf einem der Referenzpotentiale liegt und der über den anderen Eingang gesteuert wird. Die gemeinsamen gekoppelten Emitter werden jeweils von einer Stromquelle versorgt, während die Kollektoren als Ausgang des Differenzverstärkers an den Emittern weiterer Differenzverstärker der nächsten Stufe liegen. Die Pegelanpassung der Steuertransistoren, im Ausführungsbeispiel der Transistoren 10 für den Takt und 40 für den Steuereingang G erfolgt über Dioden, z.B. die Dioden 12 und 41. Bei niederohmiger Dimensionierung und einem entsprechend geringen Spannungshub an den Kollektorwiderständen der höchsten Seriesgating-Stufe lassen sich auf diese Weise schnelle Stromschalter realisieren.

Im Ausführungsbeispiel der Figur 7 steuert der Takt über die Klemme C den Transistor 10 durch, der die Stromschalter der unteren Seriesgating-Stufe aus den Transistoren 13 und 14 bzw. 25 und 26 ansteuert. Die Dateneingangsklemme D ist mit der Basis des Transistors 11 verbunden, der als Emitterfolger den Transistor 15 eines weiteren Stromschalters mit den Transistoren 15 und 16 im Ausgangskreis des Transistors 13 steuert. Im Ausgangskreis des Transistors 14 liegt ein Stromschalter mit den Transistoren 17 und 18. Die Kollektoren der Transistoren 15 und 17 bzw. 16 und 18 bilden den Ausgang des Masters; sie sind miteinander verbunden und liegen über zugeordnete Lastwiderstände 19 bzw. 20 sowie eine gemeinsame Diode 21 an dem Versorgungspotential VCC. Im Ausgangskreis des Transistors 25 des Stromschalters aus den Transistoren 25 und 26 ist der Stromschalter aus den Transistoren 27 und 28 und im Ausgangskreis des Transistors 26 der Stromschalter aus den Transistoren 29 und 30 angeordnet. Entsprechend den Transistoren 15 bis 18 des Masters sind die Kollektoren der Transistoren 27 und 29 bzw. 28 und 30 miteinander und über zugeordnete Lastwiderstände 33 bzw. 34 sowie die Diode 21 mit dem Versorgungspotential VCC verbunden. Der Verbindungspunkt der Kollektoren von 27 und 29 und des Lastwiderstands 33 bildet den Ausgang QL des Slaves und führt das dem Ausgang Q des Flip-Flops entsprechende Signal, der gemeinsame Verbindungspunkt der Kollektoren der Transistoren 28 und 30 und des zugeordneten Lastwiderstands 34 bildet den komplementären Ausgang des Slaves und führt das dem Ausgang $\overline{Q}$ des Flip-Flops zugeordnete Signal.

Damit eine Belastung der Ausgänge Q und $\overline{Q}$ des Flip-Flops keinen Einfluß auf die Laufzeiten der Multiplexerausgänge hat, werden die Flip-Flop-Ausgänge Q bzw. $\overline{Q}$ von den ihnen entsprechenden Signalen an den Kollektoren der Transistoren 27 bis 30 bzw. den Ausgängen des Slaves entkoppelt. Dazu dienen der Stromschalter aus den Transistoren 31 und 32 sowie deren Lastwiderstände 35 bzw. 36.

Die Stromschalter aus den Transistoren 17 und 18 bzw. 27 und 28 werden von den beiden Ausgängen des Masters gesteuert. Dabei liegen die Basen der Transistoren 17 und 28 am gemeinsamen Verbindungspunkt der Kollektoren der Transistoren 16 und 18 mit dem zugeordneten Lastwiderstand 20 und die Basen der Transistoren 18 und 27 am gemeinsamen Verbindungspunkt der Kollektoren von 15 und 17 mit dem zugeordneten Lastwiderstand 19. Die Basen der Transistoren 30 und 31 liegen am gemeinsamen Verbindungspunkt der Kollektoren der Transistoren 27 und 29 mit dem Lastwiderstand 33 (Slaveausgang QL entsprechend Q), und die Basen der Transistoren 29 und 32 liegen am gemeinsamen Verbindungspunkt der Kollektoren von 28 und 30 mit dem Lastwiderstand 34 (Slaveausgang entsprechend $\overline{Q}$).

Der Dateneingang "$\overline{1}$" des Multiplexers M ist gemäß Figur 2 mit dem Ausgang QL des Flip-Flops FF verbunden. Da die Dateneingänge des Multiplexers ebenso wie derjenige des Flip-Flops Stromschalter steuern, ist im Ausführungsbeispiel eine Steuerung der beiden Transistoren eines Stromschalters durch die bereits komplementäre Signale erzeugenden Ausgänge des Slaves vorgesehen. Demgemäß steuert der Ausgang QL des Flip-Flops nicht nur die Basen der Transistoren 30 und 31 des Flip-Flops, sondern auch die Basis des Transistors 45. Dieser bildet zusammen mit dem Transistor 44, der von dem Slaveausgang entsprechend $\overline{Q}$ (Abgriff am Lastwiderstand 34) gesteuert wird, einen Stromschalter des Multiplexers. Die Steuerung des Stromschalters mit den Transistoren 44 und 45 muß aber nicht zwingend mit komplementären Signalen erfolgen. Genausogut könnte Transistor 44 vom Referenzpotential VB2 gesteuert werden.

Der andere Dateneingang "1" des Multiplexers liegt am Transistor 50, dessen Basis entsprechend bezeichnet ist. Die Slaveausgänge und Transistor 50 steuern jeweils einen Stromschalter aus den Transistoren 44 und 45 bzw. 46 und 47. Diese beiden Stromschalter in der oberen Seriesgating-Stufe liegen am Ausgang der unteren Seriesgating-Stufe aus den Transistoren 42 und 43, die vom Steuereingang G über den Transistor 40 gesteuert ist. Während der Transistor 45 vom Dateneingang "$\overline{1}$" bzw. vom Slaveausgang QL gesteuert ist, liegt der Steuereingang des Transistors 44 am $\overline{Q}$ entsprechenden komplementären Ausgang des Slaves. Der Referenztransistor 46 des anderen Stromschalters liegt auf Referenzpotential VB2, während der Referenzeingang des Transistors 42 der unteren Seriesgating-Stufe auf dem Potential VB3 liegt. Die Kollektoren der Transistoren 44 und 46 sind miteinander und mit einem Anschluß des Lastwiderstands 48 verbunden, während die Kollektoren der Transistoren 45 und 47 miteinander und mit einem Anschluß des Lastwiderstands 49 verbunden sind. Beide Lastwiderstände 48 und 49 liegen andererseits an Versorgungspotential VCC. Die gemeinsamen Verbindungspunkte der Kollektoren der Stromschalter 44 bis 47 mit den zugeordneten Lastwiderständen bilden die Ausgänge QM bzw. $\overline{QM}$ des Multiplexers, wobei letzterer dem Lastwiderstand 49 zugeordnet ist.

Die Schaltung arbeitet folgendermaßen. Ein an der Dateneingangsklemme liegendes logisches Einssignal steuert den Transistor 15 durch und wird mit einem an der Takteingangsklemme C liegenden Signal, das den Transistor 13 durchsteuert, an den Ausgang des Masters übertragen. Dabei nimmt der Kollektor des Transistors 15 durch den Spannungsabfall am Lastwiderstand 19 niedriges Potential an, während durch das Sperren des Transistors 16 dessen Kollektor am Lastwiderstand 20 auf hohes Potential gehoben wird. Dieser Zustand wird nach dem Abschalten des Taktsignals, mit dem wieder der Transistor 14 durchgeschaltet wird, über die Selbsthaltung aus den Transistoren 17 und 18 gespeichert. Da der Transistor 18 vom Kollektor des Transistors 15 gesteuert wird, bleibt dieser Transistor gesperrt, so daß sein Kollektor auf hohem Potential bleibt und den Transistor 17 durchsteuert. Damit bleibt aber wiederum der Kollektor des Transistors 17 und damit die Basis des Transistors 18 auf niedrigem Potential. Gleichzeitig wird mit dem Abschalten des Taktsignals an der Klemme C der Transistor 25 durchgeschaltet, während der Transistor 28 bereits eingeschaltet ist. Der Kollektor des Transistors 28 erhält damit über den Lastwiderstand 34 niedriges Potential und nimmt logisches Nullpotential an. Entsprechend liegt der Kollektor des Transistors 27, der gesperrt ist, auf hohem Potential. Mit dem nächsten Taktsignal wird der Transistor 25 abgeschaltet und der Transistor 26 eingeschaltet. Über den Stromschalter mit den Transistoren 29 und 30 bleibt der logische Ausgang des Slaves des Flip-Flops erhalten. Über den Entkopplungsstromschalter mit den Transistoren 31 und 32 wird der logische Ausgangszustand an die Ausgangsklemmen Q und $\overline{Q}$ des Flip-Flops übertragen. Aus diesem Grund entspricht der Ausgang des Flip-Flops dem logischen Zustand am Dateneingang D im Bewertungszeitpunkt der vorausgegangenen Taktperiode. Erst mit dem Rückfallen des Taktsignals an der Klemme C wird der Transistor 26 gesperrt und der Transistor 25 durchgeschaltet, so daß die Dateninformation der zweiten Taktperiode an den Ausgang des Flip-Flops übernommen werden kann.

Im vorher beschriebenen Zustand der ersten Taktperiode befindet sich der Basisanschluß des Transistors 45 auf logischem Einspotential und der Basisanschluß des Transistors 44 auf logischem Nullpotential. Dieser logische Zustand wird über die den Transistor 40 steuernde Steuerklemme G und den Stromschalter aus den Transistoren 42 und 43 auf den Ausgang QM bzw. $\overline{QM}$ des Multiplexers übertragen, wenn der Dateneingang "$\overline{1}$" des Multiplexers durchgeschaltet wird. Das geschieht dann, wenn der Steuereingang G auf logischem Nullpotential liegt, so daß der Transistor 42 durchschaltet. Die dann durchgeschalteten Transistoren 42 und 45 bewirken über dem Lastwiderstand 49 einen Spannungsabfall, so daß der Ausgang $\overline{QM}$ logisch O und entsprechend der Ausgang QM logisch I wird. Befindet sich der Steuereingang G auf logischem Einspotential, so wird der vom Eingang "1" des Multiplexers abhängige Stromschalter aus den Transistoren 46 und 47 über den Transistor 43 betrieben.

Die Realisierung der erfindungsgemäßen Gate Array Komponentenanordnung ist aber nicht auf Common Mode Logic beschränkt. In gleich vorteilhafter Weise läßt sich die Erfindung auch mit anderen Schaltungstechniken realisieren. Ebenso ist die Erfindung nicht auf Master-Slave-Flip-Flops mit nachgeschalteter Logik beschränkt. In vorteilhafter Weise lassen sich auch Latches und RS-Flip-Flops mit nachgeschalteter Logik realisieren.

## Patentansprüche

1. Gate Array Komponentenanordnung mit einem taktgesteuerten Speicherelement (FF), **dadurch gekennzeichnet,** daß dem Speicherelement (FF) ausgangsseitig ein Multiplexer (M) nachgeschaltet ist.

2. Anordnung nach Anspruch 1, **dadurch gekennzeichnet,** daß ein logischer Ausgang (QL) des Speicherelements (FF) an einen Dateneingang ("$\overline{1}$") des Multiplexers (M) angeschlossen ist.

3. Anordnung nach Anspruch 1 oder 2, **dadurch gekennzeichnet,** daß der Daten (D)- und Takteingang (CL) des Speicherelements (FF) sowie der Steuer (G)- und weitere Dateneingang ("1") des Multiplexers (M) die Eingänge der Komponenten (Figur 2) und der Multiplexerausgang (Y,$\overline{Y}$) den Ausgang der Komponenten (Figur 2) bildet.

4. Anordnung nach einem der Ansprüche 1 bis 3, **dadurch gekennzeichnet,** daß ein weiterer Ausgang der Komponenten (Figur 2) durch den Ausgang (X,$\overline{X}$) des Speicherelements (FF) gebildet wird.

5. Anordnung nach einem der vorhergehenden Ansprüche, **gekennzeichnet** durch Ausführung in Common Mode Logic (CML).

6. Verwendung einer Gate Array Komponentenanordnung nach einem der vorhergehenden Patentansprüche als Schieberegisterzelle.

# FIG 1

# FIG 2

# FIG 3

# FIG 4

# FIG 5

# FIG 6

FIG 7